(19) **Europäisches Patentamt**
**European Patent Office**
**Office européen des brevets**

(11) **EP 2 264 796 A2**

(12) **EUROPÄISCHE PATENTANMELDUNG**

(43) Veröffentlichungstag:
22.12.2010 Patentblatt 2010/51

(51) Int Cl.:
*H01L 33/00* *(2010.01)*     *F21K 99/00* *(2010.01)*

(21) Anmeldenummer: 10185807.4

(22) Anmeldetag: 25.05.2005

(84) Benannte Vertragsstaaten:
AT BE BG CH CY CZ DE DK EE ES FI FR GB GR HU IE IS IT LI LT LU MC NL PL PT RO SE SI SK TR

(30) Priorität: 14.07.2004 DE 202004011015 U

(62) Dokumentnummer(n) der früheren Anmeldung(en) nach Art. 76 EPÜ:
05751006.7 / 1 766 695

(71) Anmelder: Ledon Lighting Jennersdorf GmbH
8380 Jennersdorf (AT)

(72) Erfinder:
• Hoschopf, Hans
8380 Jennersdorf (AT)

• Tasch, Stefan
8380 Jennersdorf (AT)
• Pachler, Peter
8042 Graz - St. Peter (AT)

(74) Vertreter: Rupp, Christian
Mitscherlich & Partner
Patent- und Rechtsanwälte
Sonnenstrasse 33
80331 München (DE)

Bemerkungen:
Diese Anmeldung ist am 01-10-2010 als Teilanmeldung zu der unter INID-Code 62 erwähnten Anmeldung eingereicht worden.

(54) **Weisse LED mit kegelfoermigem Reflektor und planaren Facetten**

(57)     Ein LED-Strahler weist auf:
- eine Anordnung mit wenigstens einer LED (8), über der ein Farbkonversionsstoff (9) angeordnet ist, und
- eine Optik (1) aus einem im wesentlichen transparenten Material, die auftreffendes Licht von der LED-Anordnung durch Totalreflexion in Richtung einer Austrittsfläche lenkt.

Die Basisfläche der Kegeloptik (1) kann dabei die Form eines Polygons aufweisen. Die Außenwand (2) der Kegeloptik (1) kann wenigstens in Teilbereichen planare Facetten (6) aufweisen.

Das Farbkonversionsmaterial (9) kann in Form eines Quaders oberhalb der LED-Anordnung (8) vorgesehen sein.

Fig. 2

EP 2 264 796 A2

**Beschreibung**

Die vorliegende Erfindung bezieht sich auf LED-Strahler.

Der Hintergrund der vorliegenden Erfindung ist das Gebiet der Leuchtdioden und insbesondere das Gebiet der 'weissen' Leuchtdioden (LEDs). Gemäß dem Stand der Technik wird zum Erzeugen von weissem Licht mittels Leuchtdioden farbiges, insbesondere blaues Licht mittels Farbkonversion oder mittels Mischung von Lichtanteilen von verschiedenfarbigen LEDs erzeugt. Beispielsweise kann das weisse Licht durch Mischung von von einem LED-Chip erzeugten blauen Licht mit gelbem Licht entstehen, welches beim Durchtritt des blauen Lichts durch ein die LEDs umgebendes Farbkonversionsmaterial aus einem Teil des blauen Lichts erzeugt wird.

Aufgrund der Eigenschaften der Farbkonversionsmaterialien und den technischen Einschränkungen bei der Fertigung der LEDs entstehen dabei oft unterschiedlich gefärbte Bereiche der über den LEDs angeordneten Farbkonversionsschicht, welche durch Abbildung derselben zu einem inhomogenen Farbverteilung führen. Dies ist insbesondere bei konventionellen Brechungslinsen der Fall. Bei brechenden Linsen ergibt sich insbesondere bei engstrahligen LEDs die Schwierigkeit, das blaue Licht mit dem gelben konvertierten Licht über den gesamten Abstrahlungsbereich derart zu vermischen, dass homogenes weisses licht abgestrahlt wird.

Bei der Erzeugung von weissem Licht ausgehend von blauen LEDs ist es schwierig, die blaue Farbe mit der gelben konvertierten Farbe über die gesamte Abstrahlbreite derart zu vermischen, dass homogenes weisses Licht abgestrahlt wird.

Aus der WO 02/50472 A1 ist eine LED-Strahleranordnung mit einem Innen offenen Reflektor bekannt. Da am Boden des Reflektors verschiedenfarbige LEDs angeordnet sind, ist keine Farbkonversion notwendig.

Aufgabe der vorliegenden Erfindung ist es, die Abstrahleigensachaften von LED-Strahlern zu verbessern.

Diese Aufgabe wird erfindungsgemäß durch die Merkmale der unabhängigen Ansprüche gelöst. Die abhängigen Ansprüche bilden den zentralen Gedanken der Erfindung in besonders vorteilhafter Weise weiter.

Gemäß einem ersten Aspekt der vorliegenden Erfindung ist also ein LED-Strahler vorgesehen, der eine Anordnung mit wenigstens einer LED sowie eine Kegeloptik aus einem im wesentlichen transparentem Vollmaterial aufweist, die sich von der LED-Anordnung weg erweitert und Licht von der LED-Anordnung durch Totalreflexion in Richtung einer Austrittsfläche der Kegeloptik lenkt. Somit mischt sich "indirektes" Licht, d.h. Licht, das an der Seitenfläche (Grenzschicht zur umgebenden Luft) der Kegeloptik totalreflektiert wurde, mit dem Lichtanteil, der ohne Reflektion "direkt" das Kegeloptikmaterial hin zur Austrittsfläche durchläuft.

Die Basisfläche der Kegeloptik kann die Form eines Polygons, Kreises, Ellipse aufweisen.

Die Seitenwand der Kegeloptik kann wenigstens in Teilbereichen planare Facetten aufweisen.

Oberhalb der LED-Anordnung, d.h. zwischen der LED-Anordnung und der Austrittsfläche, ist ein Farbkonversionsmaterial angeordnet. Das Farbkonversionsmaterial kann dabei insbesondere in Form eines Quaders angeordnet werden.

Im Falle von mehreren LEDs können diese gleichfarbig oder auch verschiedenfarbig sein.

Die LED-Anordnung kann bündig in einen Träger eingesetzt sein, der mit der Basisebene der Kegeloptik abschließt.

Weitere Vorteile, Merkmale und Eigenschaften der vorliegenden Erfindung sollen nunmehr Bezug nehmend auf die Figuren der begleitenden Zeichnungen näher erläutert werden.

Fig. 1  zeigt dabei eine schematische Ansicht des Strahlengangs in einer erfindungsgemäßen Kegeloptik,

Fig. 2  zeigt eine perspektivische Ansicht einer trichterförmigen Linse gemäß der vorliegenden Erfindung,

Fig. 3  zeigt eine schematische Schnittansicht eines Ausführungsbeispiels eines erfindungsgemäßen LED-Strahlers mit eingesetztem LED-Chip

Fig. 4  zeigt eine weitere Ausführungsform eines erfindungsgemäßen LED-Strahlers, und

Fig. 5  zeigt eine Ausführungsform mit teilverspiegelter Kegeloptik.

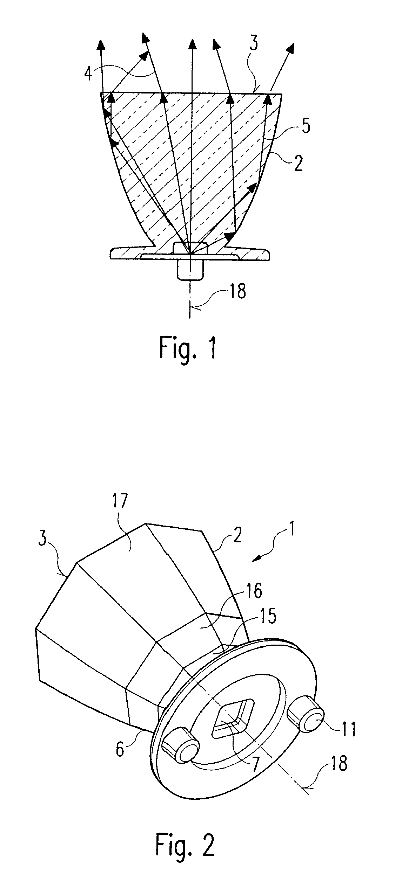

Wie in Fig. 1 ersichtlich ist gemäß der vorliegenden Erfindung für einen LED-Strahler eine trichterförmige Linse in Form einer Kegeloptik 1 aus im wesentlichen transparentem Vollmaterial vorgesehen, die Seitenwände 2 sowie eine Austrittsfläche 3 aufweist, die senkrecht zur Symmetrieachse der Kegeloptik 1 steht. Das Material der Kegeloptik kann bspw. einen Brechungsindex von 1,4 bis 1,6, insbesondere 1,50 bis 1,55 aufweisen.

An der Grenzschicht von der Kegeloptik zu der umgebenden Luft wird von Innen auftreffendes Licht totalreflektiert, so dass es an den Seitenwänden der Kegeloptik nicht austritt. Da es dagegen auf die Austrittsfläche der Kegeloptik in einem wesentlichen steileren Winkel auftritt, wird es dort nicht reflektiert, sondern lediglich von der Normalen der Austrittsfläche weggebrochen.

Durch den spitzen Winkel, den die Mantelfläche der Kegeloptik zu der Symmetrieachse einschliesst, ist sichergestellt, dass das Licht von der LED-Anordnung in einem Winkel auftrifft, der kleiner oder gleich dem Grenzwinkel für die Totalreflektion ist. Da dieser Grenzwinkel α gemäss der folgenden Gleichung

$$\sin(\alpha) = n1/n2$$

ein Funktion des Brechungsindexes n2 des Materials der Kegeloptik (und des Brechungsindexes *n1* der umgebenden Luft) ist, hängt der mögliche Verlauf der Mantelfläche der Kegeloptik von dem Brechungsindex des für die Kegeloptik gewählten Materials ab.

Vorteilhaft ist es indessen, wenn der Winkel, den die Mantelfläche zu der Symmetrieachse bildet, mit zunehmendem Abstand von der LED-Lichtquelle flacher wird.

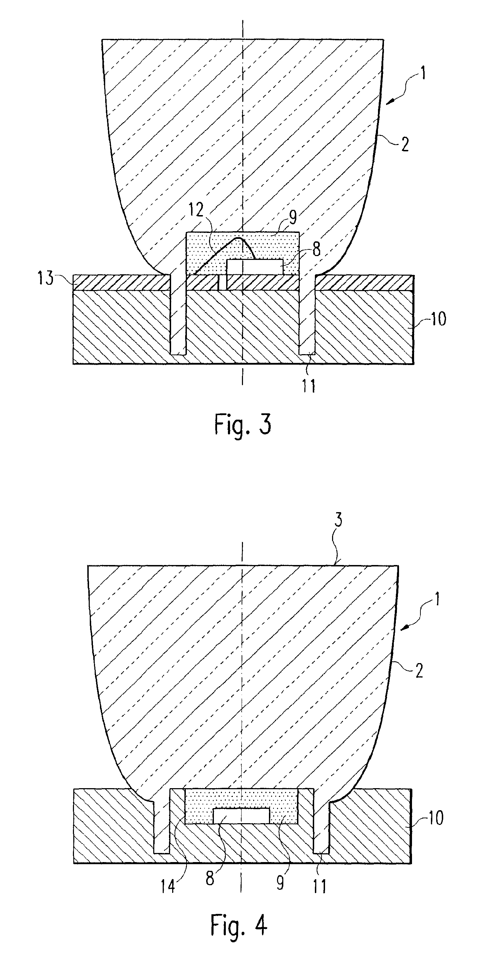

In dem Bereich mit geringerem Querschnitt der Kegeloptik 1 ist als LED-Lichtquelle beispielsweise ein LED-Chip vorgesehen, der in Figuren 3 und 4 dargestellt ist und später Bezug nehmend auf diese Figuren erläutert werden wird. Der LED-Chip weist eine LED-Anordnung mit einer oder mehreren LEDs auf.

Von diesem LED-Chip kann Licht 4 direkt in Richtung der Austrittsfläche 3 strahlen.

Indirektes Licht, das dagegen auf die Grenzfläche der Kegeloptik 1 trifft, wird dort aufgrund der entsprechend gewählten Brechungseigenschaften und des Auftrittswinkels totalreflektiert und somit in den Bereich der Austrittsfläche 3 gelenkt.

Wie in Fig. 2 ersichtlich, kann die Seitenwand 2 der Kegeloptik 1 zumindest teilweise planare Facetten 6 aufweisen.

Im unteren Bereich der Kegeloptik 1 ist eine Öffnung zum Einsetzen eines LED-Chips vorgesehen. Weiterhin kann die Unterseite der Kegeloptik 1 Befestigungsansätze 11 aufweisen, mittels derer die Kegeloptik 1 auf einem Träger positioniert und ggf. montiert werden kann.

Der LED-Strahler ist durch das Material der Kegeloptik, den Farbkonversionsstoff und die LED-Lichtquelle vollständig, d.h. ohne hohle Bereiche oder Lufteinschlüsse ausgefüllt.

In dem Ausführungsbeispiel von Fig. 3 ist die Kegeloptik 1 mittels den Befestigungsansätzen 11 in einen Träger 10 eingesetzt und positioniert. Auf der Oberseite des Trägers 10 ist eine Leiterplatte 13 vorgesehen. Im Inneren der Kegeloptik 1 ist ein LED-Chip 8 angeordnet, der gegenüber der Leiterplatte 13 an seiner Unterseite isoliert ist, aber beispielsweise mittels Bonddrähten 12 entsprechend mit dieser elektrisch kontaktiert ist. Oberhalb des LED-Chips 8 ist in Form eines Quaders Farbkonversionsmaterial 9 aufgebracht.

Das Ausführungsbeispiel von Fig. 4 unterscheidet sich von demjenigen von Fig. 3 dadurch, dass der LED-Chip 8 sowie das Farbkonversionsmaterial 9, wiederum in Form eines Quaders, in eine Vertiefung 14 in den Träger 10 bündig abschließend eingesetzt ist.

Gemäß der Erfindung wird also die Durchmischung von der Lichtfarbe, die der Ausstrahlfarbe des LED-Chips 8 entspricht, mit der Lichtfarbe, die durch die Konversion im Farbkonvertiermaterial 9 entsteht, entscheidend verbessert. Dabei erfolgt die Verbesserung der Vermischung insbesondere durch wenigstens eine der folgenden Mechanismen:

- Es wird eine Kegeloptik 1 verwendet, bei der Licht aus den seitlichen Totalreflexionsbereichen und das direkt über die ebene Deckfläche emittierte Licht überlagert wird. Dadurch wird über eine geeignete Abbildung der seitlichen Kegelwände 2 eine erste Durchmischung des Lichts erreicht.

- Die Durchmischung kann weiter verbessert werden, wenn der Kegel in mehrere Segmente unterteilt wird, welches jedes für sich bereits die gewünschte Abstrahlung generiert. Durch die Überlagerung der Abstrahlung der einzelnen Kegelbereiche (s. beispielsweise die Facetten 6 in Fig. 2) wird eine weitere Durchmischung des Lichts erreicht. Der 'Kegel' weist in diesem Fall eine polygone Basisfläche auf.

- Durch zusätzlich angebrachte Facetten 6 wird eine weitere Verbesserung der Durchmischung des Lichts erreicht; diese führt aber nur Durchmischung in den kleineren Raumwinkelbereichen durch. Weiter unten werden die Winkellagen dieser Facetten weiter spezifiziert.

- Durch die Anpassung der Geometrie des Farbkonvertierungsmaterials wird ebenfalls dafür gesorgt, dass die Emission des Lichtes in den verschiedenen Bereichen so gering wie möglich variiert. Weiterhin bleibt dadurch die Oberflächenfarbe des Farbkonvertierungsmaterials in den technisch möglichen Grenzen gleichartig.

Hinsicht der Winkellage der Facetten in der Kegeloptik sind die folgenden Bereiche vorteilhaft:

1. Lichtstrahlen von einer angenommenen Punktlichtquelle im Zentrum der Chip-Oberfläche werden in einem Winkelbereich von 0 bis 28° (im Material) direkt nach außen, d.h. zur Abstrahlfläche 3 ausgesandt.

2. In einem Winkelbereich von 28 bis 40° erfahren sie eine Totalreflexion an der Innenseite der Kegeloptik 1 von 5° zur Symmetrieachse der Kegeloptik bis zu 0°.

3. In einem Austrittsbereich von 40 bis 55° erfahren sie eine Totalreflexion von 0° bis 5° zur Symmetrieachse und von 55° bis 75° erfahren sie eine Totalreflexion von 5° zur Achse bis 0°.

Die Überlagerung der Abstrahlungen aus diesen unterschiedlichen Bereichen ergibt somit die homogene Vermischung. Die drei angesprochenen Zonen lassen sich in der Kegeloptik 1 durch Seitenwände 2 mit Kreisbögen bspw. mit tangentialem Übergang ausbilden, wie es schematisch in Fig. 2 dargestellt ist. Anstelle des tangentialen Übergangs kann indessen auch eine Kante vorliegen.

Mit 15 ist dabei der Kreisbogen der planaren Facetten bezeichnet, der die Lichtstrahlen mit dem Austrittsbereich von 55° bis 75° totalreflektiert. Mit 16 ist der Kreisbogen der planaren Facetten bezeichnet, der Licht mit dem Austrittswinkel von 40° bis 55° totalreflektiert. Schließlich ist mit 17 der Kreisbogen der planaren Facetten bezeichnet, der Licht im Bereich von 28 bis 40° totalreflektiert. Wie gesagt, Licht von einem Austrittswinkel von 0 bis 28°, stets gemessen zur Symmetrieachse 18, tritt direkt in der Austrittsfläche 3 aus.

Die in Figuren 3 und 4 dargestellte Quaderform des Farbkonversionsmaterials ermöglicht eine relativ geringe Farbvarianz an der Oberfläche des Farbkonversionsmaterials. Eine genaue relative Positionierung des LED-Chips, des Farbkonversionsmittels sowie der Kegeloptik kann dadurch erleichtert werden, dass die Kontur des Farbkonversionsmaterial formmäßig durch die Unterseite der Kegeloptik definiert ist.

Die Kegeloptik kann mit dem LED-Träger 10 in verschiedenster Weise befestigt werden. Beispielsweise kann der LED-Chip in die Kegeloptik eingebracht werden. Die Kegeloptik kann entweder in dem Träger wie in Fig. 4 gezeigt eingesetzt werden und/oder angeklebt bzw. ultraschallverschweißt werden. Alternativ dazu kann die Kegeloptik auch derart an der Basis verbreitert sein, dass sie direkt auf den Träger aufgesetzt werden kann (s. Figuren 2 und 4). In letzterem Fall kann die Positionierung bevorzugt durch die dargestellten 'Beinchen' 11 erfolgen, mit welchen die Kegeloptik in Bohrungen (s. Figuren 3 und 4) des Trägers 10 eingesetzt werden kann.

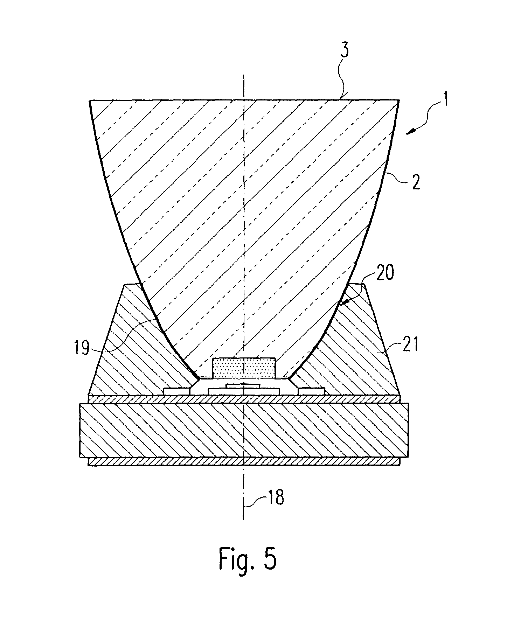

Fig. 5 zeigt ein Ausführungsbeispiel, bei dem zur Verbesserung der Effizient der Totalreflektion die Mantelfläche der Kegeloptik zumindest teilweise bspw. durch eine Aussen aufgebrachte Metallschicht 19 verspiegelt ist. Diese Metallschicht stellt nur eine Möglichkeit dafür dar, wie ein Reflektor die Totalreflektion ergänzen kann.

Durch das Vorsehen eines solchen Reflektors 19 zumindest in einem Teil der Kegeloptik kann in diesem Bereich auf die Wirkung der Totalreflektion sogar ganz verzichtet werden, so dass der LED-Strahler in diesem Bereich wie in Figur 5 gezeigt gefasst werden kann. Bspw. kann der LED-Strahler in diesem Bereich der Mantelfläche der Kegeloptik mit einem Träger 21 verklebt werden.

Wie bereits erwähnt, kann die Erzeugung von weissem Licht ausgehend von blauen oder ultravioletten LEDs mittels eines Farbkonversionsprozesses von Luminophoren erzeugt werden, welche direkt über den LED-Chip angeordnet sind. Diese Luminophoren werden in einer transparenten, thermisch und lichtstabilen Matrix wie Epoxide, Acrylate oder Silikonen, eingebettet. Alternativ dazu kann die Farbkonversionsschicht auch direkt auf den LED-Chip aufgebracht werden. Die Befestigung der Kegeloptik auf den Substrat (Träger) kann entweder durch Verklebung oder durch Verschweißung sowie jegliche mechanische Befestigung erfolgen. Als Linsenmaterial werden bevorzugt hochtransparente Kunststoffe wie beispielsweise Polycarbonat, PMMA, PMMI, COC, COP oder aber auch Glas eingesetzt.

P30433

Tridonic Optoelectronics

**Bezugszeichenliste:**

| | |
|---|---|
| 1: | trichterförmige Linse (Kegeloptik) |
| 2: | transparente Seitenwand |
| 3: | Austrittsfläche |
| 4: | direkter Lichtanteil |
| 5: | indirekter (totalreflektierter Lichtanteil) |
| 6: | Facette |
| 7: | Öffnung für LED-Die |
| 8: | LED-Die (LED-Chip) mit einer oder mehrerer LED |
| 9: | Farbkonversionmaterial |
| 10: | Träger |
| 11: | Befestigungsansatz ("Linsenbein") |
| 12: | Elektrische Kontaktierung |
| 13: | Leiterplatte |
| 14: | Vertiefung im Träger |
| 15, 16, 17: | Kreisbogenabschnitte |
| 18: | Symmetrieachse der Optik |
| 19: | Teilverspiegelung |
| 20: | Verklebung |
| 21: | Fassungsträger |

**Patentansprüche**

1. Weißlicht-LED-Strahler, aufweisend;

   - eine LED-Anordnung mit wenigstens einer LED (8) , über der ein Farbkonversionsmittel (9) angeordnet ist, und
   - eine Kegeloptik (1), wobei

   die Kegeloptik (1) vorzugsweise direkt auf einem LED-Träger (10) befestigt ist, und
   die wenigstens eine LED (8) im Inneren der Kegeloptik (1) angeordnet ist.

2. Weißlicht-LED-Strahler, aufweisend;

   - eine LED-Anordnung mit wenigstens einer LED (8) , über der ein Farbkonversionsmittel (9) angeordnet ist, und
   - eine Kegeloptik (1),

   wobei die Kontur des Farbkonversionsmittels (9) formmäßig durch die Unterseite der Kegeloptik (1) definiert ist.

3. Weisslicht LED-Strahler nach Anspruch 1 oder 2, wobei die Kegeloptik (1) in dem LED-Träger (10) eingesetzt und/oder angeklebt bzw. ultraschallverschweisst ist,

4. Weisslicht LED-Strahler nach Anspruch 1 oder 2, wobei die Kegeloptik (1) mit Befestigungsansätzen (11) in den LED-Träger (10) eingesetzt und positioniert ist.

5. Weißlicht-LED-Strahler nach einem der vorhergehenden Ansprüche,
   **dadurch gekennzeichnet, daß** auf der Oberseite des Trägers eine Leiterplatte vorgesehen ist.

6. Weißlicht-LED-Strahler nach einem der vorhergehenden Ansprüche,
   **dadurch gekennzeichnet, dass** die LED-Anordnung mehrere LEDs aufweist.

7. Weißlicht-LED-Strahler nach Anspruch 5,
   **dadurch gekennzeichnet, dass** die LEDs gleichfarbig sind.

8. Weißlicht-LED-Strahler nach Anspruch 5,
   **dadurch gekennzeichnet, dass** die LEDs verschiedenfarbig sind.

9. Weißlicht-LED-Strahler nach einem der vorhergehenden Ansprüche,
   **dadurch gekennzeichnet, dass** das Farbkonversionsmittel in einer transparenten, thermisch und lichstabilen Matrix aus Epoxide, Acrylate oder Silikonen eingebettet ist..

10. Weißlicht-LED-Strahler nach einem der vorhergehenden Ansprüche,
    **dadurch gekennzeichnet, daß** die Kontur des Farbkonversionsmittels (9) formmäßig durch die Unterseite der Kegeloptik (1) definiert ist.

11. Weißlicht-LED-Strahler nach einem der vorhergehenden Ansprüche,
    **dadurch gekennzeichnet, daß** die Basisfläche der Kegeloptik die Form eines Polygons , Kreises, oder Ellipse aufweist.

12. Weißlicht-LED-Strahler nach einem der vorhergehenden Ansprüche, **dadurch gekennzeichnet, daß** die Seitenwand der Kegeloptik wenigstens in Teilbereichen planare Facetten aufweist.

13. Weißlicht-LED-Strahler nach einem der vorhergehenden Ansprüche, **dadurch gekennzeichnet, daß** das Farbkonversionsmaterial in Form eines Quaders oberhalb der LED-Anordnung vorgesehen ist.

14. Weißlicht-LED-Strahler nach einem der vorhergehenden Ansprüche, **dadurch gekennzeichnet, daß** die Mantelfläche der Kegeloptik wenigstens teilweise verspiegelt ist.

Fig. 1

Fig. 2

Fig. 3

Fig. 4

Fig. 5

**EP 2 264 796 A2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0250472 A1